# EUROPEAN PATENT APPLICATION

(11) **EP 1 840 913 A1**
(43) Date of publication of application: **03.10.2007**
(21) Application number: 07102986.2
(22) Date of filing: 23.02.2007
(51) Int. Cl.: H01G 4/232, H01G 4/38, H01G 4/30

(54) **Capacitor and electronic circuit**

(30) Priority: 30.03.2006 JP 2006092643; 20.11.2006 JP 2006313020
(71) Applicant: Eudyna Devices Inc., Nakakoma-gun, Yamanashi 409-3883 (JP)
(72) Inventor: Kumagai, Seiji, Showa-cho Nakakoma-gun, Yamanashi 409-3883 (JP)
(74) Representative: Hitching, Peter Matthew

(57) **Abstract**

A capacitor (21) includes two sub capacitors (20a,20b) and two connecting portions (L1,L2). The two sub capacitors (20a,20b) respectively include a lower electrode (12a,12b) provided on a substrate, a dielectric film (14a,14b) provided on the lower electrode (12a,12b), and an upper electrode(16a,16b) provided on the dielectric film (14a,14b), and the two connecting (L1,L2) portions respectively connecting the lower electrode of one of the two sub capacitors and the upper electrode of the other sub capacitor of the two sub capacitors.

## Description

### BACKGROUND OF THE INVENTION

### 1. Field of the Invention

This invention generally relates to capacitors and electronic circuits, and more particularly, to a capacitor having two sub capacitors and an electronic circuit.

### 2. Description of the Related Art

Metal-Insulator-Metal (MIM) capacitors, each of which is composed of a lower electrode, a dielectric film, and an upper electrode, sequentially formed on a substrate, are for use in electronic circuits such as, for example, integrated circuits or the like. Some electronic circuits include two circuits symmetrically arranged. Symmetrical operation is demanded for such symmetrically arranged circuits. As an electronic circuit having such two symmetrical circuits, there is known a push-pull amplifier circuit. The push-pull amplifier circuit has two amplifier circuits connected in a symmetrical manner and operating in reversed phases from each other. In the push-pull amplifier circuit, an analogue input signal is divided into two signals having reversed phases by use of, for example, a balun, and each of the two signals is respectively input into the amplifier circuits. Then, the signals respectively output from the two amplifier circuits are combined by use of, for example, the balun, to form an output signal. This can reduce the distortion even when a large amount of electricity is amplified (for example, class B operation).

Japanese Patent Application Publication No. 2005-72311 discloses a MIM capacitor, in which polarities of the electrodes of the multiple capacitors are alternately arranged.

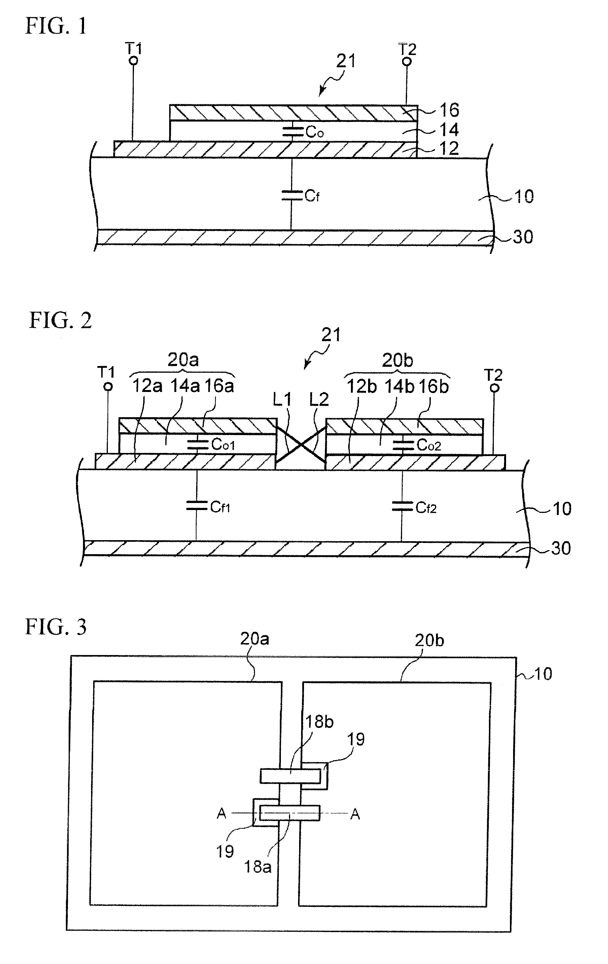

Referring now to FIG. 1, a description will be given of a conventional problem. There is provided a MIM capacitor, in which a lower electrode 12, a dielectric film 14, and an upper electrode 16, sequentially formed on the front surface of a substrate 10, and a rear surface metal film 30 is provided on the rear surface of the substrate 10. The lower electrode 12 is connected to a terminal T1, and the upper electrode 16 is connected to a terminal T2. In the aforementioned capacitor 20, in addition to a true capacitance C0 of the dielectric film 14, a parasitic capacitance Cf is applied between the lower electrode 12 and the rear surface metal film 30. Therefore, the true capacitance C0 and the capacitance corresponding to the parasitic capacitance Cf are also applied to the terminal T1. Meanwhile, no capacitance corresponding to the parasitic capacitance Cf is applied to the terminal T2. Accordingly, if the polarity of the terminal T1 and that of the terminal T2 are exchanged (namely, according to the polarity of the capacitor), the capacitance values thereof will be changed.

For instance, with respect to a capacitor connected between the two amplifier circuits serving as a push-pull amplifier circuit, if the capacitor is varied in the capacitance value thereof depending on the polarity thereof, the two amplifier circuits will not operate in a symmetrical manner. This will increase a secondary distortion in the output signal of the push-pull amplifier circuit. Therefore, the capacitor connected between such symmetrically arranged two circuits is demanded to have the capacitance value that is small in the difference according to the polarity of the capacitor.

### SUMMARY OF THE INVENTION

The present invention has been made in view of the above circumstances and provides a capacitor and an electronic circuit, in which the difference in the capacitance value due to the polarity of the capacitor can be suppressed.

According to one aspect of the present invention, there is provided a capacitor including: two sub capacitors respectively including a lower electrode provided on a substrate, a dielectric film provided on the lower electrode, and an upper electrode provided on the dielectric film; and two connecting portions respectively connecting the lower electrode of one of the two sub capacitors and the upper electrode of the other sub capacitor of the two sub capacitors. It is possible to suppress the difference in the capacitance value due to the polarity of the capacitor.

According to another aspect of the present invention, there is provided an electronic device including: two symmetrical circuits; and a capacitor connected between the two symmetrical circuits and including two sub capacitors and two connecting portions, the two sub capacitors respectively including a lower electrode provided on a substrate, a dielectric film provided on the lower electrode, and an upper electrode provided on the dielectric film; and the two connecting portions respectively connecting the lower electrode of one of the two sub capacitors and the upper electrode of the other sub capacitor of the two sub capacitors.

### BRIEF DESCRIPTION OF THE DRAWINGS

Exemplary embodiments of the present invention will be described in detail with reference to the following drawings, wherein:
FIG. 1 is a schematic cross-sectional view of a conventional capacitor;
FIG. 2 is a schematic cross-sectional view of a capacitor in accordance with a first exemplary embodiment of the present invention;
FIG. 3 is a plan view of the capacitor in accordance with the first exemplary embodiment of the present invention;
FIG. 4 is a cross-sectional view taken along the line A-A of FIG. 3;
FIG. 5 is a plan of the capacitor in accordance with a second exemplary embodiment of the present invention;
FIG. 6 shows a circuit diagram of an electronic circuit in accordance with the third exemplary embodiment of the present invention;
FIG. 7 is a schematic cross-sectional view of the capacitor in accordance with a fourth exemplary embodiment of the present invention; and
FIG. 8 is a schematic cross-sectional view of the capacitor in accordance with a fifth exemplary embodiment of the present invention.

### DESCRIPTION OF THE PREFERRED EMBODIMENTS

A description will now be given, with reference to the accompanying drawings, of exemplary embodiments of the present invention.

### (First Exemplary Embodiment)

FIG. 2 is a schematic cross-sectional view of a capacitor in accordance with a first exemplary embodiment of the present invention. There is provided a rear surface metal film 30 made, for example, of gold on the rear surface (backside of the substrate) of a GaAs substrate 10. There are provided, on the front surface of the substrate 10: lower electrodes 12a and 12b made, for example, of gold; dielectric films 14a and 14b made, for example, of silicon nitride film, respectively provided on the lower electrodes 12a and 12b; and upper electrodes 16a and 16b made, for example, of gold, respectively provided on the dielectric films 14a and 14b, the front surface of the substrate 10 being an opposite surface of the rear surface thereof. That is to say, the rear surface metal film 30 is provided on the rear surface, which is the opposite surface of the front surface on which the lower electrodes 12a and 12b are provided. The lower electrodes 12a and 12b, the dielectric films 14a and 14b, and the upper electrodes 16a and 16b respectively compose sub capacitors 20a and 20b respectively having true capacitances C01 and C02.

The lower electrode 12a and the upper electrode 16b are connected by a connecting portion L1, and the lower electrode 12b and the upper electrode 16a are connected by a connecting portion L2. In this manner, two connecting portions L1 and L2 alternately connect one of the lower electrodes 12a and 12b and one of the upper electrodes 16b and 16a in the two sub capacitors 20a and 20b. In other words, the lower electrode 12a and the upper electrodes 16b are connected and the lower electrode 12b and the upper electrodes 16a are connected. The two sub capacitors 20a and 20b and the connecting portions L1 and L2 compose a capacitor 21. The output from the capacitor 21 is implemented by terminals T1 and T2 respectively connected to the lower electrodes 12a and 12b. The terminals T1 and T2 may be connected to the upper electrodes 16a and 16b, respectively. That is to say, the output from the capacitor 21 is extracted from the two lower electrodes 12a and 12b or the two upper electrodes 16a and 16b.

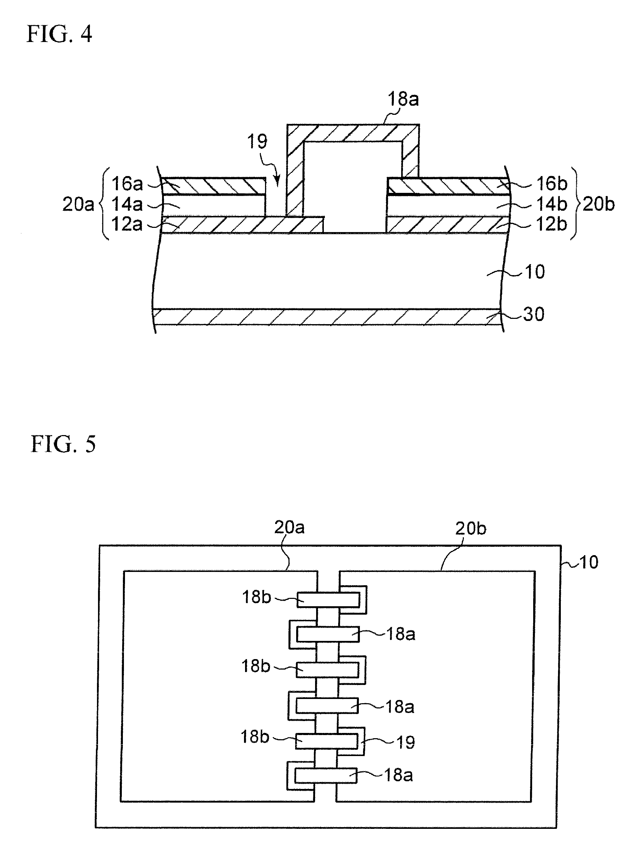

FIG. 3 is a plan view of the capacitor in accordance with the first exemplary embodiment of the present invention. There are formed the two sub capacitors 20a and 20b on the substrate 10, the sub capacitors 20a and 20b being connected by two interconnections 18a and 18b, respectively corresponding to the connecting portions L1 and L2. FIG. 4 is a cross-sectional view taken along the line A-A of FIG. 3. The lower electrode 12a of the sub capacitor 20a and the upper electrode 16b of the sub capacitor 20b are connected by the interconnection 18a made of gold. The dielectric film 14a and the upper electrode 16a is removed in a region 19 where the interconnection 18a is connected to the lower electrode 12a, in FIG. 3 and FIG. 4. Thus, the interconnection 18a is connected to the lower electrode 12a.

In the first exemplary embodiment, a parasitic capacitance Cf1 is applied to the lower electrode 12a of the sub capacitor 20a and a parasitic capacitance Cf2 is applied to the lower electrode 12b of the sub capacitor 20b, as shown in FIG. 2. The upper electrodes and the lower electrodes of the two sub capacitors 20a and 20b are alternately connected by connecting portions L1 and L2. This applies a capacitance relating to the parasitic capacitance Cf1 to the terminal T1, and applies a capacitance relating to the parasitic capacitance Cf2 to the terminal T2. It is therefore possible to suppress the difference in the capacitance value due to the polarity of the capacitor 21.

It is preferable that the lower electrode 12a of the sub capacitor 20a and the lower electrode 12b of the sub capacitor 20b have the same size. This makes the parasitic capacitance Cf1 and the parasitic capacitance Cf2 almost equal, thereby suppressing the difference in the capacitance value due to the polarity of the capacitor 21.

Also, in FIG. 3, it is preferable that the interconnections 18a and 18b be closed to each other. Currents flowing across the interconnections 18a and 18b in opposite directions generate a current loop. This will generate a magnetic field coupling with another element other than the capacitor 21. By arranging the interconnections 18a and 18b closer to each other, the current loop can be made smaller and the generation of the magnetic field coupling can be suppressed.

### (Second Exemplary Embodiment)

FIG. 5 is a plan of the capacitor in accordance with a second exemplary embodiment of the present invention. Hereinafter, in the second exemplary embodiment, the same components and configurations as those employed in the first exemplary embodiment have the same reference numerals and a detailed explanation will be omitted. In the second exemplary embodiment, there are provided multiple interconnections 18a and multiple interconnections 18b. That is, the multiple interconnections 18a and 18b are arranged at adjacent sides of the sub capacitors 20a and 20b, namely, at the sides between the sub capacitors 20a and 20b in FIG. 5. This makes it possible to divide the current flowing between the sub capacitors 20a and 20b. It is therefore possible to suppress the generation of the magnetic field coupling with another element due to the current loop.

In the first and second exemplary embodiments, since a microwave circuit uses the interconnection as a microstrip line, the rear surface metal film 30 is provided on the rear surface of the substrate 10. This applies the parasitic capacitance Cf1 and Cf2 to the lower electrodes 12a and 12b. As stated, it is effective to use the capacitor employed in the first or second exemplary embodiment in the microwave circuit that utilizes the microstrip line.

Also, in the first and second exemplary embodiments, a description has been given of a case where the GaAs substrate is employed for the substrate 10. A semiconductor substrate made of Si, InP, or the like may be employed for the substrate 10. An insulating substrate such as ceramic substrate or the like may be employed. In particular, the substrate 10 where the capacitor 21 is provided has a thickness of approximately 100 µm and the parasitic capacitance Cf1 and Cf2 is large in a monolithic IC in which an active element such as a transistor or the like and a capacitor are integrated into an identical substrate. Therefore, it is effective to employ the technique of the first or second exemplary embodiment.

An example has been given of a case where gold is used for the lower electrodes 12a and 12b, the upper electrodes 16a and 16b, the rear surface metal film 30, and interconnections 18a and 18b. However, another metal film such as aluminum, copper, or the like may be employed. Another example has been given of a case where the interconnections 18a and 18b are respectively employed for the connecting portions L1 and L2. However, the present invention is not limited to the type of the interconnection as far as the lower electrode 12a of the sub capacitor 20a and the lower electrode 12b of the sub capacitor 20b are respectively connected with the upper electrodes 16b and 16a.

### (Third Exemplary Embodiment)

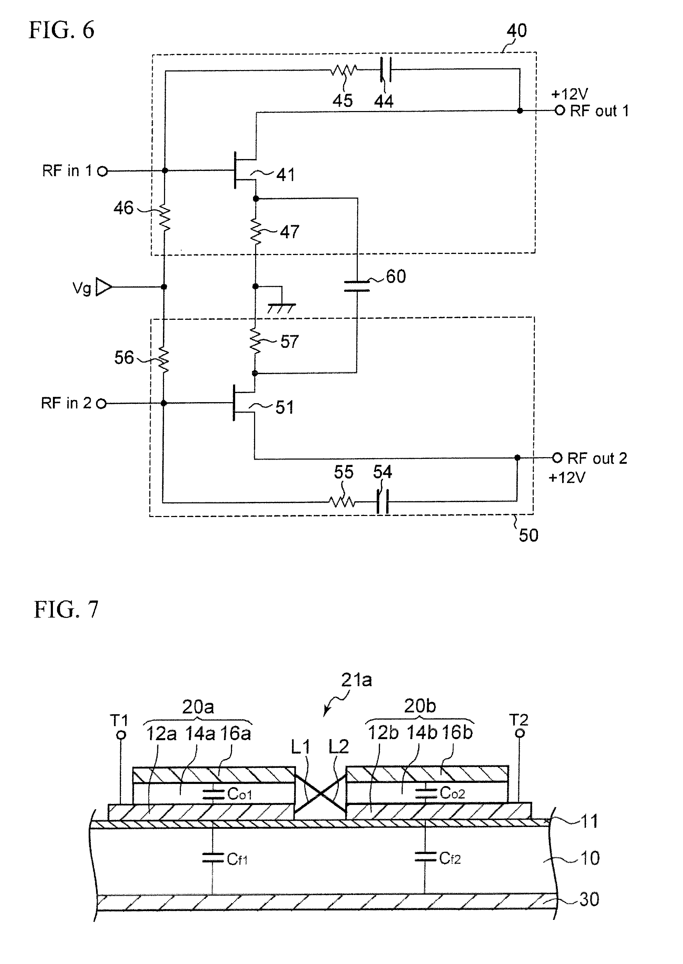

A third exemplary embodiment of the present invention is an example of a push-pull amplifier circuit in which the capacitor employed in the first exemplary embodiment is used for an electronic circuit having two symmetrical circuits therein. FIG. 6 shows a circuit diagram of the electronic circuit in accordance with the third exemplary embodiment of the present invention. There are provided two symmetrical amplifier circuits (simply referred to as circuits) 40 and 50. The amplifier circuit 40 includes an FET 41. An input RFin1 of an RF signal is input and connected through the gate of the FET 41 and also connected through a resistor 45 and a capacitor 44, to an output RFout1. The input Rfin1 is also connected through a resistor 46 to a power supply Vg. The source of the FET 41 is connected through a resistor 47 to ground, and is also connected to a capacitor 60 commonly shared by the amplifier circuit 50. The drain of the FET 41 is connected to the output RFout1. For example, 12 V is applied to the output RFout1. The amplifier circuit 50 is arranged in a symmetrical manner to the amplifier circuit 40, and the above-described FETs, the capacitors, and the resistors are formed in the GaAs substrate 10.

If the capacitor 60 connected between the two amplifier circuits 40 and 50 has different capacitance values due to the polarity, the amplifier circuits 40 and 50 will amplify the RF signals in opposite phases in an asymmetrical manner. If the outputs from the amplifier circuits 40 and 50 are combined under the above-described circumstance, a secondary distortion will be generated. In the third exemplary embodiment, when the capacitor employed in the first exemplary embodiment is used for the capacitor 60, it is possible to operate the amplifier circuits 40 and 50 in a symmetrical manner. This can suppress the generation of the secondary distortion.

The lower electrode 12a of the sub capacitor 20a and the lower electrode 12b of the sub capacitor 20b may have arbitrary areas within a range of suppressing the secondary distortion, when the sub capacitor 20a and the sub capacitor 20b included in the capacitor 21 employed in the first exemplary embodiment is used as the capacitor 60. In particular, it is preferable that the above-described areas be equal. This can further suppress the difference in the capacitance value according to the polarity of the capacitor 21. In addition, the capacitor employed in the second exemplary embodiment may be used for the capacitor 60.

In the third exemplary embodiment, a description has been given of an example in which the push-pull amplifier circuit is employed as an electronic circuit having two symmetrical circuits therein. In such electronic circuit having therein the two circuits arranged in a symmetrical manner, the two circuits have to operate in a symmetrical manner. If the capacitor connected between the two circuits is varied in the capacitance value depending on the polarity thereof, the two circuits cannot operate in a symmetrical manner. Therefore, the two circuits can be operated in a symmetrical manner by using the capacitor employed in the first or second exemplary embodiment in the above-described electronic circuit.

### (Fourth Exemplary Embodiment)

FIG. 7 is a schematic cross-sectional view of the capacitor in accordance with a fourth exemplary embodiment of the present invention. Referring now to FIG. 7, an insulating film 11 is provided on the substrate 10, and the lower electrode 12a of the sub capacitor 20a and the lower electrode 12b of the sub capacitor 20b are provided on the insulating film 11. Hereinafter, in the fourth exemplary embodiment, the same components and configurations as those of FIG. 2 used in the first exemplary embodiment have the same reference numerals and a detailed explanation will be omitted. In accordance with the fourth exemplary embodiment, the insulating film 11 may be provided between the substrate 10 and the lower electrodes 12a and 12b. The present invention is not limited to the configuration in which the lower electrodes are directly provided on the substrate. When the insulating film 11 is provided between the substrate 10 and the lower electrodes 12a and 12b, it is possible to suppress the effect of parasitic capacitance components Cf1 and Cf2 respectively below the lower electrodes 12a and 12b. The insulating film 11 may be an interlayer insulating film that includes a single-layer interconnection or multilayer interconnections.

### (Fifth Exemplary Embodiment)

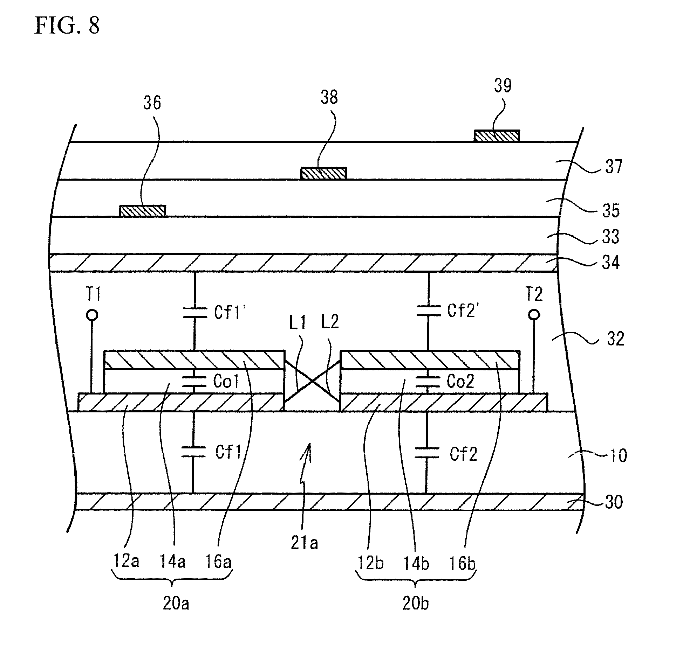

FIG. 8 is a schematic cross-sectional view of the capacitor in accordance with a fifth exemplary embodiment of the present invention. Referring now to FIG. 8, another dielectric film 32 serving like an interlayer insulating film is provided on the upper electrodes 16a and 16b, and a wiring 34 is provided on the another dielectric film 32. There are stacked interlayer insulating films 33, 35, and 37, on the wiring 34. Wirings 36, 38, and 39 are respectively provided on the interlayer insulating films 33, 35, and 37. Hereinafter, in the fifth exemplary embodiment, the same components and configurations as those of FIG. 2 used in the first exemplary embodiment have the same reference numerals and a detailed explanation will be omitted.

In accordance with the configuration employed in the fifth exemplary embodiment, it is possible to suppress the difference in the capacitance value according to the polarity of the capacitor, the difference being caused by parasitic capacitances Cf1' and Cf2' respectively generated between the upper electrodes 16a and 16b and the wiring 34. In addition, if the wiring 34 serves as a ground interconnection, there will be generated the parasitic capacitances Cf1' and Cf2'. Therefore, it is effective that the two connecting portions L1 and L2 respectively connect the lower electrode 12a of the sub capacitor 20a and the upper electrode 16b of the sub capacitor 20b, and the lower electrode 12b of the sub capacitor 20b and the upper electrode 16a of the sub capacitor 20a.

In addition, there are provided one or more layers of interconnections on the wiring 34 in the fifth exemplary embodiment. A microstrip line can be made up of one or more layers of interconnections (the wirings 36, 38, and 39) by making the wiring 34 serve as ground so as to be a pattern (ground plane) that covers the whole surface. The wiring 34 serving as a ground plane causes the parasitic capacitances Cf1' and Cf2' respectively generated between the upper electrodes 16a and 16b and the wiring 34 to be greater than those of the case where the wiring 34 is a ground interconnection. Accordingly, it is effective that the two connecting portions L1 and L2 respectively connect the lower electrode 12a of the sub capacitor 20a and the upper electrode 16b of the sub capacitor 20b, and the lower electrode 12b of the sub capacitor 20b and the upper electrode 16a of the sub capacitor 20a.

In the first through fifth exemplary embodiments, if the rear surface metal film 30 is grounded, the parasitic capacitances Cf1 and Cf2 are larger. Therefore, it is effective that the two connecting portions L1 and L2 respectively connect the lower electrode 12a of the sub capacitor 20a and the upper electrode 16b of the sub capacitor 20b, and the lower electrode 12b of the sub capacitor 20b and the upper electrode 16a of the sub capacitor 20a.

In addition, the capacitor employed in the second exemplary embodiment may include the insulating film 11 employed in the fourth exemplary embodiment. Also, the capacitor employed in the second exemplary embodiment may include another dielectric film 32 and the wiring 34 employed in the fifth exemplary embodiment. Furthermore, the capacitor 60 employed in the third exemplary embodiment may include a capacitor 21a employed in the fourth exemplary embodiment and the capacitor 21a employed in the fifth exemplary embodiment.

According to an aspect of the present invention, there is provide a capacitor including: two sub capacitors respectively including a lower electrode provided on a substrate, a dielectric film provided on the lower electrode, and an upper electrode provided on the dielectric film; and two connecting portions respectively connecting the lower electrode of one of the two sub capacitors and the upper electrode of the other of the two sub capacitors, and the lower electrode of the other of the two sub capacitors and the one of the two sub capacitors.

Although a few specific exemplary embodiments employed in the present invention have been shown and described, it would be appreciated by those skilled in the art that changes may be made in these exemplary embodiments without departing from the principles and spirit of the invention, the scope of which is defined in the claims and their equivalents.

The present invention is based on Japanese Patent Application No. 2006-092643 filed on March 30, 2006 and Japanese Patent Application No. 2006-313020 filed on November 20, 2006, the entire disclosure of which is hereby incorporated by reference.

## Claims

1. A capacitor comprising:
two sub capacitors respectively including a lower electrode provided on a substrate, a dielectric film provided on the lower electrode, and an upper electrode provided on the dielectric film; and
two connecting portions respectively connecting the lower electrode of one of the two sub capacitors and the upper electrode of the other sub capacitor of the two sub capacitors.

2. The capacitor as claimed in claim 1, further comprising a metal film provided at a rear surface of the substrate, the rear surface being an opposite surface of a front surface of the substrate on which the lower electrode is provided.

3. The capacitor as claimed in claim 1, wherein the lower electrode of the one of the two sub capacitors has an area substantially equal to that of the lower electrode of the other of the two sub capacitors.

4. The capacitor as claimed in claim 1, wherein there are provided two or more connecting portions at adjacent sides of the two sub capacitors.

5. The capacitor as claimed in claim 1, further comprising an insulating film provided between the substrate and the lower electrode.

6. The capacitor as claimed in claim 1, further comprising:
another dielectric film; and
a wiring provided on said another dielectric film.

7. The capacitor as claimed in claim 6, wherein the wiring is a ground wiring.

8. The capacitor as claimed in claim 6, wherein:
the wiring is a ground plane; and
there are provided one or more wiring layers on the wiring.

9. The capacitor as claimed in claim 1, wherein the insulating film includes a single layer wiring or multiple layer wirings.

10. An electronic device comprising:
two symmetrical circuits; and
a capacitor connected between the two symmetrical circuits and comprising two sub capacitors and two connecting portions,
the two sub capacitors respectively including a lower electrode provided on a substrate, a dielectric film provided on the lower electrode, and an upper electrode provided on the dielectric film; and
the two connecting portions respectively connecting the lower electrode of one of the two sub capacitors and the upper electrode of the other sub capacitor of the two sub capacitors.

11. The electronic device as claimed in claim 10, further comprising a metal film provided at a rear surface of the substrate, the rear surface being an opposite surface of a front surface of the substrate on which the lower electrode is provided.

12. The electronic device as claimed in claim 10, wherein the lower electrode of the one of the two sub capacitors has an area substantially equal to that of the lower electrode of the other of the two sub capacitors.

13. The electronic device as claimed in claim 10, wherein there are provided two or more connecting portions at adjacent sides of the two sub capacitors.

14. The electronic device as claimed in claim 10, wherein the two symmetrical circuits compose a push-pull amplifier circuit.
